# EUROPEAN PATENT APPLICATION

(11) **EP 2 296 270 A2**
(43) Date of publication of application: **16.03.2011**
(21) Application number: 10174682.4
(22) Date of filing: 31.08.2010
(51) Int. Cl.: H03G 3/34, H03F 1/30

(54) **Method for removing pop-up noise in mobile device**

(30) Priority: 02.09.2009 KR 20090082593
(71) Applicant: SAMSUNG ELECTRONICS CO., LTD., Suwon-si, Gyeonggi-do (KR)
(72) Inventor: Jung, Ra Mi, Gyeonggi-do (KR); Cho, Chi Hyun, Gyeonggi-do (KR)
(74) Representative: Jenkins, Richard Gavin

(57) **Abstract**

A method is provided to remove an unexpected pop-up noise that occurs while audio data such as a key tone is output in an electronic device. The method includes detecting an interruption such as a key release for stopping the output of audio data, and verifying Pulse Code Modulation (PCM) data of the audio data. If there is a gap between an endpoint of the PCM data and a given reference value, the device reduces the gap by revising the endpoint of the PCM data.

## Description

### BACKGROUND OF THE INVENTION

### 1. Field of the Invention:

The present invention relates to a mobile device. More particularly, the present invention relates to a method for removing pop-up noise resulting from an output stop in audio data in a mobile device.

### 2. Description of the Related Art:

In mobile devices, an unexpected pop-up noise may sometimes occur while audio data such as a key tone is output. The pop-up noise is a large pulse that is produced at a time when the output of audio data is suddenly stopped due to an interruption.

All electronic devices such as a mobile device that are capable of outputting audio data may unexpectedly encounter pop-up noise. Naturally, the pop-up noise may depend on the time when the output of audio data is stopped. In addition, the pop-up noise may only occur by means of Pulse Coding Modulation (PCM) of data without any changes to an audio path and without interference by hardware noises.

The pop-up noise that occurs during audio data output in the mobile device may result in user discomfort and inconvenience.

Therefore, a need exists for a method for removing pop-up noise in a mobile device.

### SUMMARY OF THE INVENTION

An aspect of the present invention is to address at least the above-mentioned problems and/or disadvantages and to provide at least the advantages described below. Accordingly, an aspect of the present invention is to provide a method for removing pop-up noise in a mobile device.

Another aspect of the present invention is to provide a method for removing pop-up noise occurring when audio data output is stopped due to interruption in a mobile device.

Still another aspect of the present invention is to provide a method for removing pop-up noise in connection with a key tone output in a mobile device.

Yet another aspect of the present invention is to provide a method for removing pop-up noise occurring when a key tone output is stopped prior to the expiration of a preset output duration due to interruption in a mobile device.

Further an aspect of the present invention is to provide a method for removing pop-up noise by revising an endpoint of a key tone to converge on a given reference value when a key tone output is stopped due to interruption.

Still a further aspect of the present invention is to provide a method for removing pop-up noise by delaying the output stop time of a key tone until the time when an endpoint of a key tone converges on a given reference value rather than the time when interruption occurs, if an endpoint of a key tone fails to converge on the given reference value at that interruption time.

In accordance with an aspect of the present invention, a method for removing pop-up noise in an electronic device is provided. The method includes detecting an interruption for stopping the output of audio data, verifying Pulse Coding Modulation (PCM) data of the audio data, and, when there is a gap between an endpoint of the PCM data and a given reference value, reducing the gap by revising the endpoint of the PCM data.

The verifying of the PCM data may include analyzing a sine curve obtained from the PCM data and determining whether the endpoint of the sine curve converges on the reference value at the time of the interruption.

The revising of the endpoint may include converging the endpoint on the reference value before or after the time of the interrupt.

If the endpoint fails to converge on the reference value, the reducing of the gap may include adding data to the PCM data so that the endpoint converges on the reference value.

If the endpoint fails to converge on the reference value, the reducing of the gap may include erasing data after the last point among points of the PCM data converging on the reference value so that the endpoint converges on the reference value.

The reducing of the gap may include analyzing an end slope of the sine curve at the time of the interruption if the endpoint of the PCM data fails to converge on the reference value, if the end slope has an inward direction to the reference value, extending the sine curve to the reference value so that the endpoint converges on the reference value, and if the end slope has an outward direction from the reference value, erasing the sine curve after the last point among points of the sine curve converging on the reference value so that the endpoint converges on the reference value.

The pop-up noise may occur when the interruption occurs before a preset output duration of the audio data ends.

In accordance with another aspect of the present invention, a method for removing pop-up noise in an electronic device is provided. The method includes outputting a key tone in response to a received key input, analyzing a sine curve of the key tone when detecting a key release during the output of the key tone, stopping the output of the key tone at the time of the key release if an endpoint of the sine curve converges on a given reference value, revising the key tone if the endpoint of the sine curve fails to converge on the reference value, and stopping the output of the key tone at the time when the endpoint of the sine curve of the revised key tone converges on the reference value.

In accordance with still another aspect of the present invention, a method for removing pop-up noise in an electronic device is provided. The method includes detecting an interruption for stopping the output of audio data, analyzing a sine curve of the audio data, when there is a gap between an endpoint of the sine curve and a given reference value, revising the sine curve, and stopping the output of the audio data at the endpoint of the revised sine curve.

Other aspects, advantages, and salient features of the invention will become apparent to those skilled in the art from the following detailed description, which, taken in conjunction with the annexed drawings, discloses exemplary embodiments of the invention.

### BRIEF DESCRIPTION OF THE DRAWINGS

The above and other aspects, features, and advantages of certain exemplary embodiments of the present invention will be more apparent from the following description taken in conjunction with the accompanying drawings, in which:

FIG. 1 illustrates a key tone output in response to a key press that is longer than a preset output duration of the key tone in a mobile device according to an exemplary embodiment of the present invention.

FIGs. 2A and 2B illustrate a key tone output in response to a key press that is shorter than a preset output during a key tone in a mobile device and an example of pop-up noise according to an exemplary embodiment of the present invention.

FIGs. 3A and 3B illustrate a method for removing pop-up noise occurring when a key tone output is stopped according to an exemplary embodiment of the present invention.

FIGs. 4A and 4B illustrate a method for removing pop-up noise occurring when a key tone output is stopped according to an exemplary embodiment of the present invention.

FIGs. 5A and 5B illustrate a method for removing pop-up noise occurring when a key tone output is stopped according to an exemplary embodiment of the present invention.

FIG. 6 is a flow diagram illustrating a method for removing pop-up noise in a mobile device according to an exemplary embodiment of the present invention.

FIG. 7 is a flow diagram illustrating a method for removing pop-up noise in a mobile device according to an exemplary embodiment of the present invention.

Throughout the drawings, it should be noted that like reference numbers are used to depict the same or similar elements, features, and structures.

### DETAILED DESCRIPTION OF EXEMPLARY EMBODIMENTS

The following description with reference to the accompanying drawings is provided to assist in a comprehensive understanding of exemplary embodiments of the invention as defined by the claims and their equivalents. It includes various specific details to assist in that understanding but these are to be regarded as merely exemplary. Accordingly, those of ordinary skill in the art will recognize that various changes and modifications of the embodiments described herein can be made without departing from the spirit and scope of the invention. Also, descriptions of well-known functions and constructions are omitted for clarity and conciseness.

The terms and words used in the following description and claims are not limited to the bibliographical meanings, but, are merely used by the inventor to enable a clear and consistent understanding of the invention. Accordingly, it should be apparent to those skilled in the art that the following description of exemplary embodiments of the present invention are provided for illustration purpose only and not for the purpose of limiting the invention as defined by the appended claims and their equivalents.

It is to be understood that the singular forms "a," "an," and "the" include plural referents unless the context clearly dictates otherwise. Thus, for example, reference to "a component surface" includes reference to one or more of such surfaces.

Exemplary embodiments of the present invention provide a method for removing pop-up noise resulting from a stop in audio data output in a mobile device. More particularly, exemplary embodiments of the present invention provide a method for removing pop-up noise through software-based processing regardless of any change of audio paths or interference by hardware such as a speaker. Furthermore, exemplary embodiments of the present invention provide a method for removing pop-up noise in electronic devices including, but not limited to, a mobile device when the audio data output is suddenly stopped.

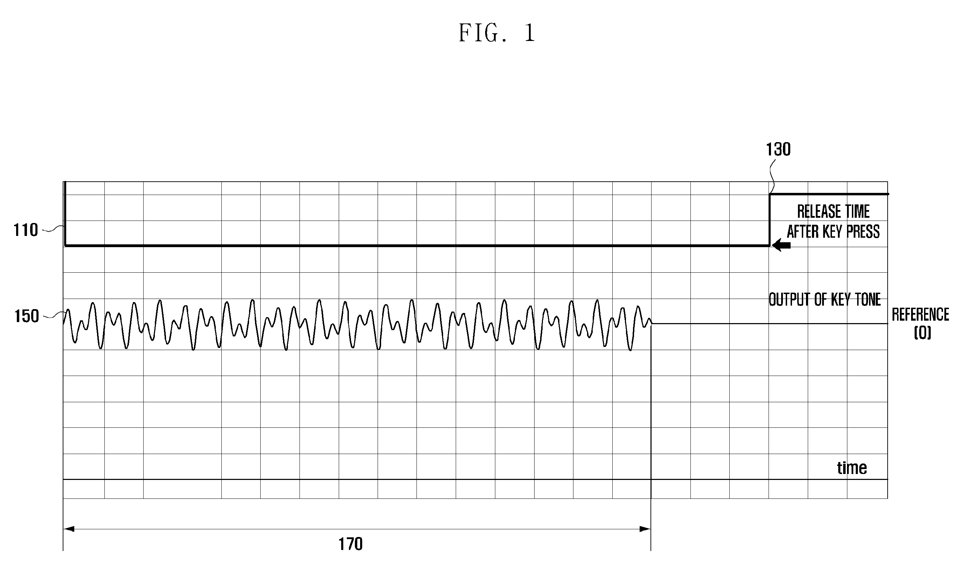

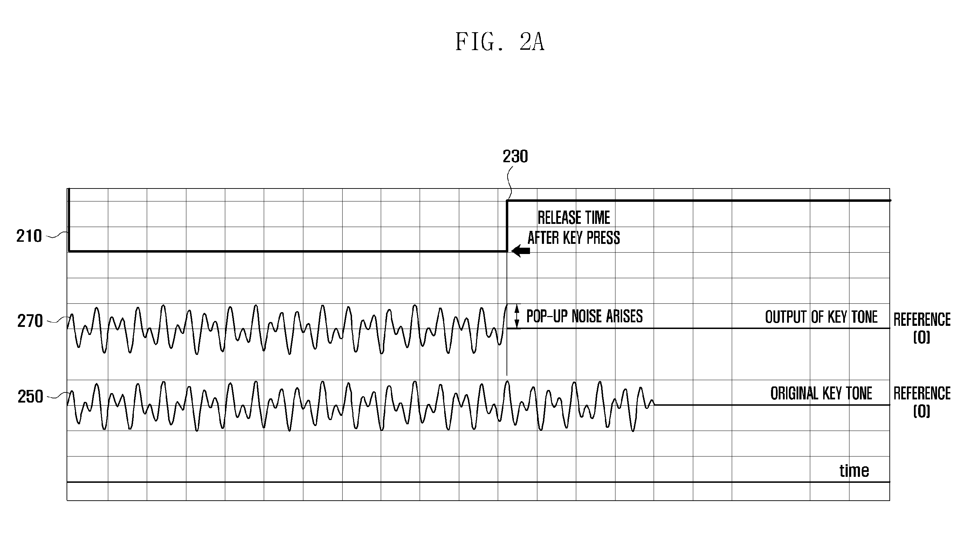

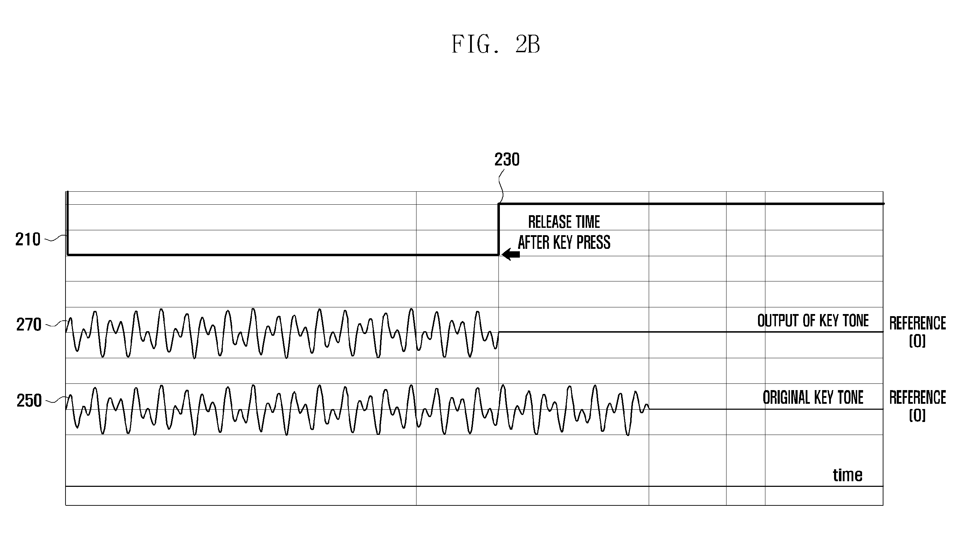

Normally, in an electronic device capable of outputting audio data, the output of audio data such as a key tone may be suddenly stopped. At this time, an unexpected pop-up noise may occur due to Pulse Coding Modulation (PCM) of data without any change of an audio path and without interference by hardware noises, based on the output stop time of the audio data. The pop-up noise will be described in more detail below with reference to FIGs. 1, 2A and 2B.

FIG. 1 illustrates a key tone output in response to a key press that is longer than a preset output duration of a key tone in a mobile device according to an exemplary embodiment of the present invention. FIGs. 2A and 2B illustrate a key tone output in response to a key press that is shorter than a preset output during a key tone in a mobile device and an example of pop-up noise according to an exemplary embodiment of the present invention.

FIGs. 1, 2A and 2B illustrate a sine curve of a key tone as an example of audio data. Typically, a key tone is output when each alphanumeric key is pressed in any operation mode (e.g., a dialing mode) of a mobile device.

FIG. 1 illustrates a case where a certain key is pressed longer than a preset output duration of a key tone assigned to a pressed key according to an exemplary embodiment of the present invention.

Referring to FIG. 1, reference number 110 denotes a key press start time, i.e., the time when a user's key press occurs, and reference number 130 denotes a key release time, i.e., the time when the user's key press is released. Additionally, reference number 150 denotes a sine curve of a key tone assigned to a pressed key, and reference number 170 denotes a preset output duration of the key tone.

As illustrated in FIG. 1, the key tone output begins at the key press start time 110 and continues within a preset output duration while the key press is maintained without releasing the key press. This is a normal case in which an entire key tone is completely output since the key press is longer than the preset output duration of the key tone. That is, as denoted by reference number 130, the key release occurs after the output of the key tone is complete. In this case, pop-up noise may not occur.

On the contrary, FIGs. 2A and 2B illustrate a case where a certain key is pressed shorter than a preset output duration of a key tone assigned to a pressed key.

Referring to FIGs. 2A and 2B, reference number 210 denotes a key press start time, and reference number 230 denotes a key release time. Additionally, reference number 250 denotes a sine curve of a key tone originally assigned to a pressed key in a case where a key tone is output until the preset output duration expires. Meanwhile, reference number 270 denotes a sine curve of the key tone in a case where the output of the key tone is stopped by the key release before the preset output duration expires.

As illustrated in FIGs. 2A and 2B, the key tone output starts at the key press start time 210. The output of the key tone continues during the key press and stops at the key release time. More specifically, FIGs. 2A and 2B illustrate a case in which an entire key tone is not completely output since the key press is shorter than the preset output duration of the key tone. In this case, pop-up noise may occur, based on a wave form of the sine curve at the key release time. FIG. 2A illustrates a case in which the pop-up noise occurs, and FIG. 2B illustrates a case in which the pop-up noise does not occur.

Referring to FIG. 2A, at the time of the key release, the sine curve of the key tone stops at a distance far from the reference value. In this case, the pop-up noise may occur when the output of the key tone is stopped. For example, if an endpoint of the sine curve is separated from the reference value when the output of the key tone is suddenly stopped due to the key release, the pop-up noise is created instantaneously in the form of a large pulse.

Referring to FIG. 2B, at the time of the key release, the sine curve of the key tone stops at a distance close to the reference value. In this case, the pop-up noise may not occur when the output of the key tone is stopped. For example, if an endpoint of the sine curve is very close to the reference value when the key tone output is suddenly stopped due to the key release, the pop-up noise is not created and the output of the key tone is normally stopped.

As described above, audio data (e.g., a key tone) output in response to a user's key press may cause an unexpected pop-up noise, based on a relationship between the key release time and a preset output duration of the audio data. More specifically, if the audio data output is stopped due to the key release before the original output duration expires, the pop-up noise may occur according to the wave form of the sine curve at the key release time. That is, if the endpoint of the sine curve is separated from the reference value (e.g., zero) at the key release time, the pop-up noise is created.

Therefore, the pop-up noise that may occur when the audio data output is stopped compulsorily due to the key release prior to the expiration of the preset output duration may be removed according to an exemplary embodiment of the present invention. In an exemplary implementation, the pop-up noise may be removed by analyzing the sine curve at the key release time and then revising the endpoint of the sine curve to converge on the reference value. In this case, a revision for the endpoint of the sine curve may be varied based on whether an end slope of the sine curve approaches the reference value.

Exemplary methods for revising the audio data will be described in more detail below. The following examples are exemplary only and should not limit the scope of the invention.

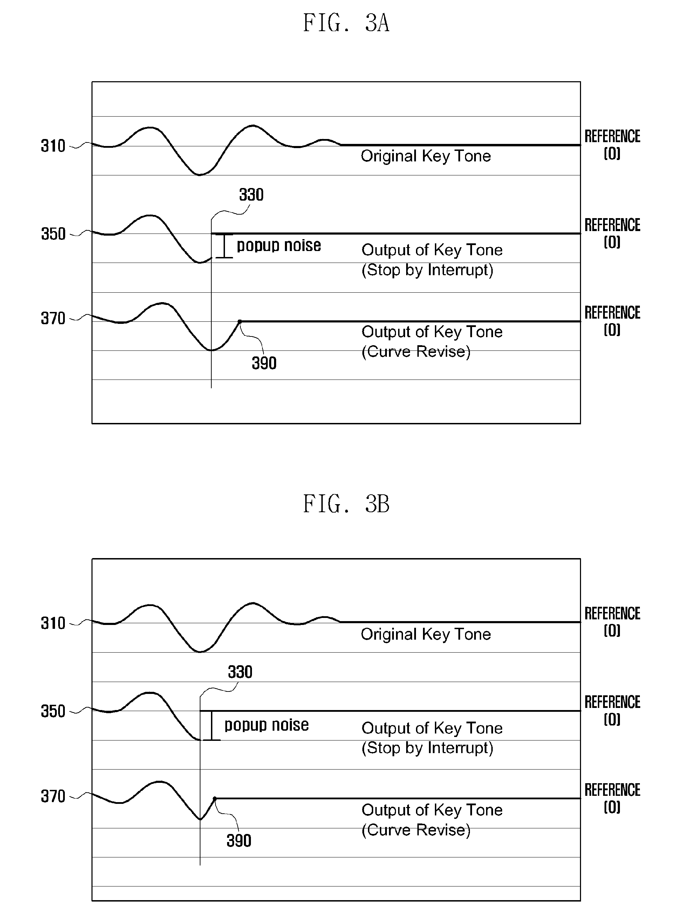

FIGs. 3A and 3B illustrate a method for removing pop-up noise occurring when a key tone output is stopped according to an exemplary embodiment of the present invention.

Audio data as illustrated in FIGs. 3A and 3B may be revised by making an endpoint of a sine curve converge on a reference value.

Referring to FIGs. 3A and 3B, reference number 310 denotes a preset sine curve of a key tone originally assigned to a pressed key, i.e., in a case where a key tone is output until a preset output duration expires. Reference number 330 denotes the key release time, and reference number 350 denotes an actual sine curve of the key tone in a case where pop-up noise occurs, i.e., in which an endpoint of the sine curve is separated from the reference value when the key tone output is stopped in response to a key release. Additionally, reference number 370 denotes a revised sine curve of the key tone in which the sine curve is extended to converge on the reference value, and reference number 390 denotes a new endpoint of the sine curve after being revised.

Referring to FIGs. 3A and 3B, the revision method to remove the pop-up noise extends the sine curve of the key tone so that an endpoint 390 of the sine curve may approach the reference value. More particularly, FIGs. 3A and 3B illustrate examples adopting a method for reducing a gap between the endpoint 390 of the sine curve and the reference value by extending the sine curve where the endpoint of the actual sine curve 350 is separated from the reference value.

More specifically, FIG. 3A illustrates an example of the key tone output in which an actual sine curve 350 has an inward end slope, i.e., an end slope that runs toward the reference value. In this case, as denoted by reference number 370, the sine curve of the key tone is revised, i.e., extended, so that the endpoint 390 of the sine curve may converge on the reference value. Additionally, the key tone output is stopped at the revised end point 390 on the reference value rather than at the key release time 330. The key tone output is stopped in response to a virtual key release instead of an actual key release. Therefore, the gap between the endpoint 390 of the sine curve and the reference value is reduced. Thereby, an unexpected pop-up noise is removed.

On the other hand, FIG. 3B illustrates an example of the key tone output in which the actual sine curve 350 has an outward end slope. In this case, as well as in the above case, as denoted by reference number 370, the sine curve of the key tone is revised, i.e., extended, so that the endpoint 390 of the sine curve may converge on the reference value. Additionally, the key tone output is stopped at the revised end point 390 on the reference value rather than the key release time 330. That is, the key tone output is stopped in response to the virtual key release instead of the actual key release. Therefore, the gap between the endpoint 390 of the sine curve and the reference value is reduced. Thereby, the unexpected pop-up noise is removed.

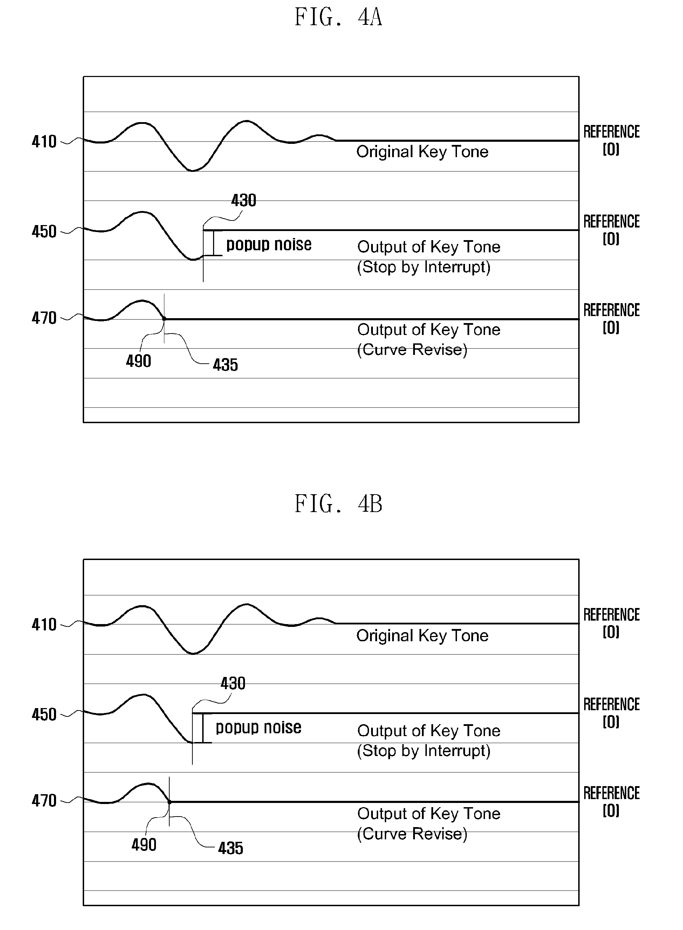

FIGs. 4A and 4B illustrate a method for removing pop-up noise occurring when a key tone output is stopped according to an exemplary embodiment of the present invention.

More particularly, a revision method illustrated in FIGs. 4A and 4B uses a last point just before a key release among points of a sine curve converging on a reference value.

Referring to FIGs. 4A and 4B, reference number 410 denotes a preset sine curve of a key tone originally assigned to a pressed key, i.e., in a case where a key tone is output until a preset output duration expires. Reference number 430 denotes the key release time, and reference number 450 denotes an actual sine curve of the key tone in a case where pop-up noise occurs, i.e., in which an endpoint of the sine curve is separated from the reference value when the key tone output is stopped in response to the key release. Additionally, reference number 490 denotes the last point just before an actual key release 430 among points of the sine curve converging on the reference value, reference number 435 denotes a virtual key release corresponding to the last point 490, and reference number 470 denotes a revised sine curve of a key tone in which a portion after the virtual key release 435 is erased and hence the endpoint converges on the reference value.

In FIGs. 4A and 4B, in the revision method to remove the pop-up noise, the last point 490 before the actual key release 430 among points of the sine curve converging on the reference value is selected and then a portion of the sine curve after the last point 490 is erased. Consequently, the revised sine curve 470 has an endpoint converging on the reference value. More specifically, FIGs. 4A and 4B illustrate examples adopting a method for reducing a gap between the endpoint of the sine curve and the reference value by erasing the sine curve after the last point 490 converging on the reference value, in a case where the endpoint of the actual sine curve 450 is separated from the reference value.

More specifically, FIG. 4A illustrates an example of the key tone output in which the actual sine curve 450 has an inward end slope, i.e., an end slope that runs toward the reference value. In this case, as denoted by reference number 470, the sine curve of the key tone after the last point 490 converging on the reference value is erased and the output of the key tone is stopped at the last converging point 490 rather than at the key release time 430. The output of the key tone is stopped in response to the virtual key release 435 produced at the last converging point 490 instead of in response to the actual key release 430. Therefore, the gap between the endpoint of the sine curve and the reference value is reduced. Thereby, an unexpected pop-up noise is removed.

On the other hand, FIG. 4B illustrates an example of the key tone output in which the actual sine curve 450 has an outward end slope. In this case as well as in the above case, as denoted by reference number 470, the sine curve of the key tone after the last point 490 converging on the reference value is erased and the output of the key tone is stopped at the last converging point 490 rather than at the key release time 430. That is, the output of the key tone is stopped in response to the virtual key release 435 produced at the last converging point 490 instead of at the actual key release 430. Therefore, the gap between the endpoint of the sine curve and the reference value is reduced. Thereby, the unexpected pop-up noise is removed.

As described above, exemplary embodiments of the present invention illustrated in FIGs. 3A to 4B provide a method for removing pop-up noise that may occur when the audio data output is stopped compulsorily due to the key release interruption prior to the expiration of the preset output duration. More particularly, for removing the pop-up noise, FIGs. 3A and 3B adopt a revision method for adding data, and FIGs. 4A and 4B adopt a revision method for erasing data.

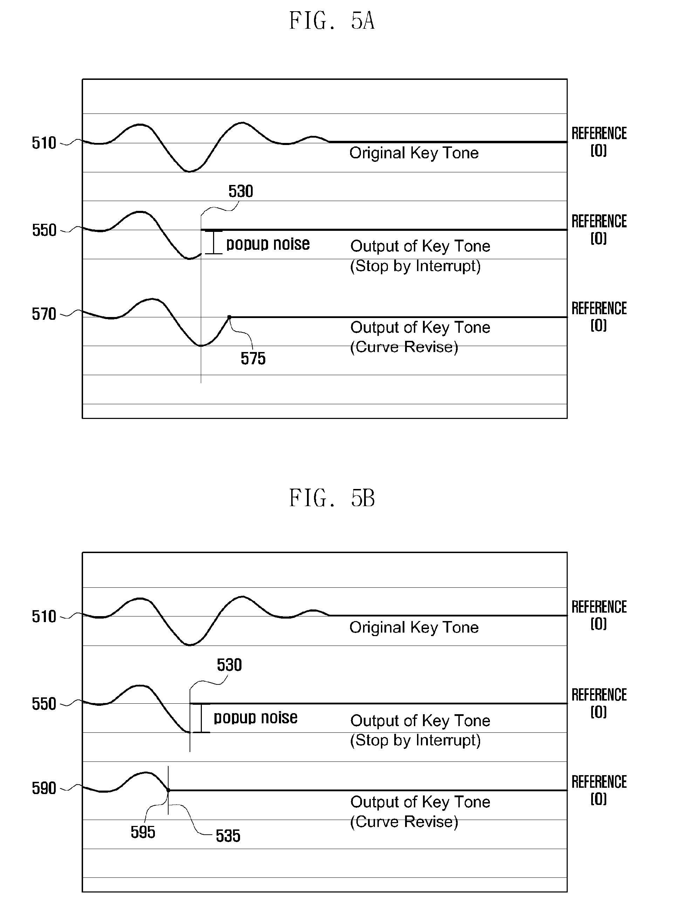

Meanwhile, with reference to FIGs. 5A and 5B, the methods between both revisions may be adopted. That is, the following methods to remove pop-up noise as illustrated in FIGs. 5A and 5B may be selectively used based on the type of end slope of a sine curve.

FIGs. 5A and 5B illustrate a method for removing pop-up noise occurring when a key tone output is stopped according to an exemplary embodiment of the present invention.

More particularly, a revision method illustrated in FIGs. 5A and 5B analyzes a sine curve around an interruption time and then adds data or erases data based on whether an end slope of a sine curve approaches a reference value.

Referring to FIGs. 5A and 5B, reference number 510 denotes a preset sine curve of a key tone originally assigned to a pressed key, i.e., in a case where a key tone is output until a preset output duration expires. Reference number 530 denotes the key release time, and reference number 550 denotes an actual sine curve of a key tone in a case where pop-up noise occurs, i.e., in which an endpoint of a sine curve is separated from a reference value when the output of the key tone is stopped in response to a key release. Additionally, reference number 570 denotes a revised sine curve of the key tone in which the sine curve is extended to converge on the reference value, and reference number 575 denotes a new endpoint of the sine curve after being revised. Furthermore, reference number 595 denotes the last point just before an actual key release 530 among points of a sine curve converging on a reference value, reference number 535 denotes a virtual key release corresponding to the last point 595, and reference number 590 denotes a revised sine curve of the key tone in which a portion after the virtual key release 535 is erased and hence the endpoint converges on the reference value.

Referring to FIGs. 5A and 5B, the revision method to remove pop-up noise either extends the sine curve of the key tone in order for the endpoint to approach the reference value (illustrated in FIG. 5A) or erases a portion of the sine curve after the last point before the actual key release 530 among points of the sine curve converging on the reference value (illustrated in FIG. 5B), based on whether the end slope of the sine curve approaches a reference value. More particularly, FIGs. 5A and 5B illustrate a combined method of the methods illustrated in FIGs. 3A to 4B.

More specifically, as described above in FIG. 3A, FIG. 5A illustrates an example of a key tone output in which the actual sine curve 550 has an inward end slope, i.e., an end slope that runs toward the reference value. In this case, as denoted by reference number 570, the sine curve of the key tone is revised, i.e., extended, so that the endpoint 575 of the sine curve may converge on the reference value. Additionally, the output of the key tone is stopped at the revised end point 575 on the reference value rather than at the key release time 530. More particularly, the key tone output is stopped in response to the virtual key release instead of in response to the actual key release. Therefore, a gap between the endpoint of the sine curve and the reference value is reduced. Thereby, an unexpected pop-up noise is removed.

On the other hand, as described above in FIG. 4B, FIG. 5B illustrates an example of a key tone output in which the actual sine curve 550 has an outward end slope. In this case as well as in the above case, as denoted by reference number 590, the sine curve of the key tone after the last point 595 converging on the reference value is erased and the output of the key tone is stopped at the last converging point 595 rather than at the key release time 530. That is, the output of the key tone is stopped in response to the virtual key release 535 produced at the last converging point 595 instead of at the actual key release. Therefore, the gap between the endpoint of the sine curve and the reference value is reduced. Thereby, the unexpected pop-up noise is removed.

In summary, exemplary embodiments of the present invention illustrated in FIGs. 5A and 5B analyze the end slope of the sine curve if the end point of the sine curve fails to converge on the reference value. Then, the sine curve is erased after the last converging point if the end slope has an outward direction, i.e., becomes more distant from the reference value, or the sine curve is extended to the reference value if the end slope has an inward direction, i.e., approaches the reference value. By increasing or decreasing the sine curve according to the type of end slope, a gap between the endpoint of the sine curve and the reference value may be reduced.

As described above, in an electronic device capable of outputting audio data, if the output of the audio data such as a key tone is suddenly stopped due to interruption and the endpoint of its sine curve is separated from the reference value, pop-up noise may occur. As described in FIGs. 3A to 5B, the aforesaid pop-up noise is substantially removed by converging the endpoint of the sine curve on the reference value and hence reducing the gap between the endpoint and the reference value.

A method for removing pop-up noise in a mobile device will be described below according to an exemplary embodiment of the present invention. The following method is exemplary only and should not limit the scope of the invention.

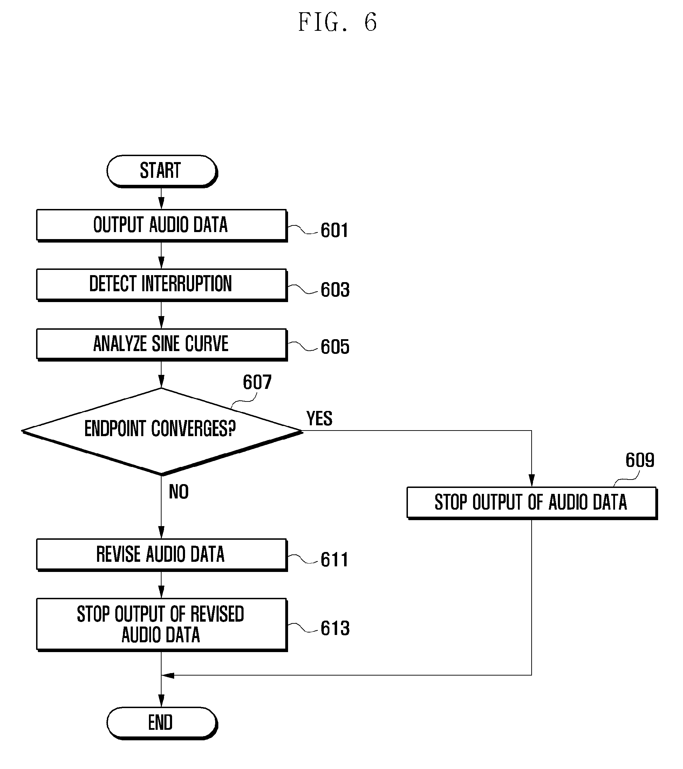

FIG. 6 is a flow diagram illustrating a method for removing pop-up noise in a mobile device according to an exemplary embodiment of the present invention.

Referring to FIG. 6, at the outset, the mobile device outputs audio data at a user's request in step 601. Here, a user's request may be a user's pressing action on a selected key. Therefore, the output of the audio data may be the output of a key tone assigned to a pressed key.

The mobile device determines whether there is an interruption for stopping the output of the audio data in step 603. Here, the interruption may be a user's releasing action from the pressed key. That is, a user may release the key after a certain time from a key press.

The mobile device analyzes a sine curve of the audio data at the time of the key release in step 605. The mobile device may analyze the endpoint of the sine curve and its end slope at the key release time. In addition, the mobile device determines whether the endpoint converges on a given reference value such as zero in step 607.

If it is determined that the endpoint converges on the given reference value in step 607, the mobile device stops the output of the audio data without any revision of the audio data in step 609.

On the contrary, if it is determined that the endpoint fails to converge on the given reference value in step 607, the mobile device performs a preset revision of the audio data in step 611. More specifically, the mobile device revises the sine curve of the audio data. Here, as discussed above in FIGs. 3A to 5B, the revision is to either extend or erase the sine curve of the audio data so that the endpoint of the sine curve may converge on the reference value.

At the time when the endpoint of the sine curve converges on the reference value by the revision method such as addition or erasure of data, the mobile device stops the output of the audio data in step 613. Here, the mobile device may create a virtual key release at the time when the endpoint of the sine curve converges on the reference, and then may stop the output of the audio data such as the key tone in response to the virtual key release.

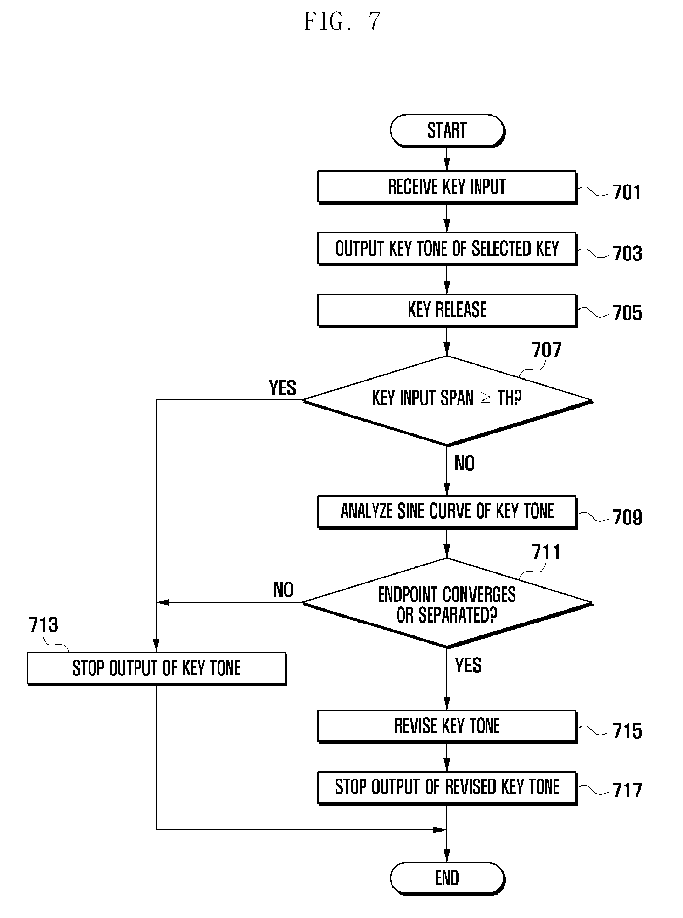

FIG. 7 is a flow diagram illustrating a method for removing pop-up noise in a mobile device according to an exemplary embodiment of the present invention.

Referring to FIG. 7, at the outset, the mobile device receives a key input from a user in step 701. The mobile device then outputs a preset key tone assigned to a selected key in response to the above user's key input in step 703. Thereafter, the mobile device determines whether a key is released from the above selected key in step 705.

The mobile device determines whether a key input span is equal to or greater than a given threshold value (Th) at the time of the key release in step 707. More specifically, the mobile device determines whether the length of time from a key input to a key release is equal to or greater than a given threshold value (Th). Accordingly, the mobile device may verify whether a certain key is pressed longer or shorter than a preset output duration of a key tone. Thus, in step 707, whether the key tone is output until a preset output duration expires may be determined.

If it is determined that the key input span is equal to or greater than a threshold value (Th) in step 707, the mobile device normally stops the output of a key tone in step 713. That is, if it is determined that the selected key is pressed longer than the preset output duration of the key tone, the mobile device closes the output of a key tone according to the preset output duration of the key tone.

On the contrary, if is determined that the key input span is smaller than the threshold value (Th) in step 707, the mobile device analyzes the sine curve of the key tone in step 709. That is, if the selected key is pressed shorter than the preset output duration of the key tone, the mobile device analyzes the endpoint of the sine curve and its end slope.

In step 709, the analysis of the sine curve may include receiving the key tone from a memory, performing a Pulse Coding Modulation (PCM) process for the received key tone, and then analyzing resultant PCM data. More particularly, the analysis may verify whether the endpoint of PCM data is separated from the reference value. Normally, PCM is a digital representation of an analog signal in which the magnitude of the signal is sampled regularly at uniform intervals. This is often referred to as a sampling of signals based on time division. The magnitude of the sampled signal has simple values through quantization. Quantized magnitude values are expressed by means of a binary notation and then converted into pulses, thus producing a pulse signal (i.e., a digital signal) of a continuously varying signal (i.e., an analog signal).

Additionally, the mobile device determines whether the endpoint of the sine curve converges on or is separated from the reference value, using the above analysis results in step 711.

If it is determined that the endpoint of a sine curve converges on the reference value in step 711, the mobile device stops the output of the key tone in step 713. That is, the mobile device normally stops the output of the key tone without any revision of the key tone in response to the key release time.

On the contrary, if it is determined that the endpoint of the since curve is separated from the reference value in step 711, the mobile device performs a preset revision of the key tone in step 715. That is, the mobile device revises the sine curve of the key tone. Here, as described above in FIGs. 3A to 5B, the revision is to either extend or erase the sine curve of the key tone so that the endpoint of the sine curve may converge on the reference value.

At the time when the endpoint of the sine curve converges on the reference value by revision such as addition or erasure of data, the mobile device stops the output of the key tone in step 717. Here, the mobile device may create a virtual key release at the time when the endpoint of the sine curve converges on the reference, and then may close the output of the key tone in response to the virtual key release.

As described above, if any interruption occurs to stop the output of the audio data, the mobile device analyzes the sine curve (i.e., PCM data) of the audio data at the time of the interruption. Also, if there is a gap between the endpoint of the sine curve and the reference value, the mobile device removes pop-up noise by reducing the gap.

Although exemplary embodiments of the present invention use a key tone as an example of audio data and a key release as interruption for stopping a key tone output, the key tone and the key release are exemplary only and should not limit the scope of the invention.

Alternatively, any other type of audio data such as MP3 file data may be used, and any other type of interruption such as power-off may be used for stopping the output of the audio data. For example, if an interruption occurs to turn off the power while a selected MP3 file is playing, the mobile device analyzes a sine curve of the MP3 file data at the interruption time. The mobile device reduces a difference from a reference value by performing a revision process as described above before turning off the power. Therefore, the mobile device can remove pop-up noise due to the power-off and hence may perform a normal process related to the power-off.

As described above, exemplary embodiments of the present invention provide a method for removing pop-up noise in an electronic device, such that pop-up noise occurring unexpectedly in audio data such as a key tone can be easily removed. More particularly, the exemplary embodiments of the present invention provide a method for removing pop-up noise occurring when the output of audio data is stopped before a preset output duration expires. Accordingly, user's discomfort and inconvenience caused by the sudden output stop of audio data may be eliminated.

In accordance with the exemplary embodiments of the present invention, when the output of audio data is stopped due to interruption occurring before the preset output duration expires, PCM data of the audio data can be revised and a virtual interruption based on the revision of PCM data can be provided. In addition, the output of audio data at the virtual interruption time continues rather than at the actual interruption time in order to remove the pop-up noise.

The above-described methods according to the present invention can be realized in hardware or as software or computer code that can be stored in a recording medium such as a CD ROM, an RAM, a floppy disk, a hard disk, or a magneto-optical disk or downloaded over a network, so that the methods described herein may be rendered in such software using a general purpose computer, or a special processor or in programmable or dedicated hardware, such as an Application Specific Integrated Circuit (ASIC) or Field Programmable Gate Array (FPGA). As would be understood in the art, the computer, the processor or the programmable hardware include memory components, e.g., RAM, ROM, Flash, and the like, that may store or receive software or computer code that when accessed and executed by the computer, processor or hardware implement the processing methods described herein. In addition, it would be recognized that when a general purpose computer accesses code for implementing the processing shown herein, the execution of the code transforms the general purpose computer into a special purpose computer for executing the processing shown herein.

While the invention has been shown and described with reference to certain exemplary embodiment thereof, it will be understood by those skilled in the art that various changes in form and details may be made therein without departing from the spirit and scope of the invention as defined by the appended claims and their equivalents.

## Claims

1. A method for removing pop-up noise in an electronic device, the method comprising:
detecting an interruption for stopping the output of audio data;
verifying Pulse Coding Modulation (PCM) data of the audio data; and
when there is a gap between an endpoint of the PCM data and a given reference value, reducing the gap by revising the endpoint of the PCM data.

2. The method of claim 1, wherein the verifying of the PCM data includes analyzing a sine curve obtained from the PCM data and determining whether an endpoint of the sine curve converges on the reference value at the time of the interrupt.

3. The method of claim 2, wherein the revising of the endpoint includes converging the endpoint on the reference value at least one of before and after the time of the interrupt.

4. The method of claim 3, wherein the reducing of the gap includes, if the endpoint fails to converge on the reference value, adding data to the PCM data so that the endpoint converges on the reference value.

5. The method of claim 3, wherein the reducing of the gap includes, if the endpoint fails to converge on the reference value, erasing data after the last point among points of the PCM data converging on the reference value so that the endpoint converges on the reference value.

6. The method of claim 3, wherein the reducing of the gap comprises:
analyzing an end slope of the sine curve at the time of the interruption if the endpoint of the PCM data fails to converge on the reference value;
if the end slope has an inward direction to the reference value, extending the sine curve to the reference value so that the endpoint converges on the reference value; and
if the end slope has an outward direction from the reference value, erasing the sine curve after the last point among points of the sine curve converging on the reference value so that the endpoint converges on the reference value.

7. The method of claim 1, wherein the output of audio data includes outputting a key tone in response to a received key input, and the interruption includes detecting at least one of a key release and a power-off.

8. The method of claim 7, the method comprising:
outputting the key tone in response to the received key input;
analyzing a sine curve of the key tone when detecting a key release during the output of the key tone;
stopping the output of the key tone at the time of the key release if an endpoint of the sine curve converges on a given reference value;
revising the key tone if the endpoint of the sine curve fails to converge on the reference value; and
stopping the output of the key tone at the time when the endpoint of the sine curve of the revised key tone converges on the reference value.

9. The method of claim 8, wherein the analyzing of the sine curve includes determining whether the endpoint of the sine curve converges on the reference value at the time of the key release.

10. The method of claim 9, wherein the analyzing of the sine curve includes determining whether there is a gap between the endpoint of the sine curve and the reference value.

11. The method of claim 10, wherein the revising of the key tone includes converging the endpoint on the reference value at least one of before and after the time of the key release.

12. The method of claim 11, wherein the revising of the key tone includes extending the sine curve so that the endpoint converges on the reference value.

13. The method of claim 11, wherein the revising of the key tone includes erasing a portion of the sine curve after the last point among points of the sine curve converging on the reference value so that the endpoint converges on the reference value.

14. The method of claim 11, wherein the revising of the key tone comprises:
analyzing an end slope of the sine curve at the time of the key release if the endpoint of the since curve fails to converge on the reference value;
if the end slope has an inward direction to the reference value, extending the sine curve to the reference value so that the endpoint converges on the reference value; and
if the end slope has an outward direction from the reference value, erasing the sine curve after the last point among points of the sine curve converging on the reference value so that the endpoint converges on the reference value.

15. The method of claim 8, wherein the pop-up noise occurs when the key release occurs before a preset output duration of the key tone.
